# EUROPEAN PATENT SPECIFICATION

(11) **EP 3 255 250 B1**
(45) Date of publication and mention of the grant of the patent: **01.04.2026**
(21) Application number: 17156328.1
(22) Date of filing: 15.02.2017
(51) Int. Cl.: F01D 5/28, C23C 16/04, C23C 16/06

(54) **METHOD FOR SIMULTANEOUSLY DEPOSITING MULTIPLE COATINGS ON A TURBINE BLADE OF A GAS TURBINE ENGINE**
VERFAHREN ZUR GLEICHZEITIGEN AUFBRINGUNG VON MEHREREN BESCHICHTUNGEN AUF EINE ROTORSCHAUFEL EINES GASTURBINENTRIEBWERKS
PROCÉDÉ PERMETTANT DE DÉPOSER SIMULTANÉMENT PLUSIEURS REVÊTEMENTS SUR UNE AUBE DE TURBINE D'UN MOTEUR À TURBINE À GAZ

(30) Priority: 18.02.2016 US 201615046716
(43) Date of publication of application: 13.12.2017
(73) Proprietor: General Electric Company, Evendale, OH 45215 (US)
(72) Inventor: GUPTA, Bhupendra Kumar, Cincinnati OH 45215 (US); TAN, Boon Hing, 508726 Singapore (SG); XIE, Liangde, Greenville SC 29615-4614 (US); BRADEN, Tamara, Evandale OH 45069 (US)
(74) Representative: Openshaw & Co.

(56) References cited:
- EP-A1- 1 790 753
- EP-A2- 2 253 464
- WO-A1-2015/047783
- US-A- 3 958 047
- US-A- 5 308 399
- US-A1- 2013 115 097
- US-A1- 2014 287 143

## Description

### FIELD OF THE INVENTION

The present invention relates generally to gas turbine engines turbines, and more specifically, to systems and methods for simultaneously depositing multiple coatings on a turbine blade of a gas turbine engine.

### BACKGROUND OF THE INVENTION

A gas turbine engine generally includes, in serial flow order, a compressor section, a combustion section, a turbine section and an exhaust section. In operation, air enters an inlet of the compressor section where one or more axial or centrifugal compressors progressively compress the air until it reaches the combustion section. Fuel is mixed with the compressed air and burned within the combustion section to provide combustion gases. The combustion gases are routed from the combustion section through a hot gas path defined within the turbine section and then exhausted from the turbine section via the exhaust section.

In particular configurations, the turbine section includes, in serial flow order, a high pressure (HP) turbine and a low pressure (LP) turbine. The HP turbine and the LP turbine each include various rotatable turbine components such as a rotor shaft, rotor disks mounted or otherwise carried by the rotor shaft, turbine blades mounted to and radially extending from the periphery of the disks, and various stationary turbine components such as stator vanes or nozzles, turbine shrouds, and engine frames. The rotatable and stationary turbine components at least partially define the hot gas path through the turbine section. For example, the gas turbine buckets or blades generally have an airfoil shape designed to convert the thermal and kinetic energy of the flow path gases into mechanical rotation of the rotor. As the combustion gases flow through the hot gas path, thermal energy is transferred from the combustion gases to the rotatable and stationary turbine components.

Turbine blades may be constructed of a number of superalloys (e.g., nickel-based superalloys), as well as ceramic matrix composites coated with an environmental barrier coating to avoid oxidation and recession in the presence of high temperature steam during operation of the engine. Current coating processes for engine components include a two-step process that first includes coating a first portion of the component with a corrosion-resistant coating (such as a chromide coating) and then subsequently includes coating a second portion of the component with an oxidation-prohibiting coating, such as an aluminide coating. For example, for high-pressure turbine blades, the shank is coated by placing the shank in a pack and filling the pack with a powder chromide coating. A later step includes coating the airfoil with an aluminide coating.

One of the issues associated with conventional two-step coating techniques, however, includes chloride gases leaking from the pack during the chromide coating process and damaging the airfoil. More specifically, in engine components with internal aluminide coatings, the depletion of aluminum due to reaction with chloride gases can result in low engine performance and/or a high scrap rate.

In view of the aforementioned, an improved system and method for coating gas turbine engine components would be advantageous. More specifically, a system and method for simultaneously depositing multiple coatings on a component of a gas turbine engine so as to not degrade such coatings would be desired in the art.

US 2013/0115097 A1 relates to corrosion-resistant diffusion coatings.

EP1790753A1 discloses a method for simultaneous coating of a blade in which a first part of a blade is placed in a masking chamber with a lid. In this document the opening of the chamber through which the blade is inserted needs to be tightly adapted to the dimension of the blade.

### BRIEF DESCRIPTION OF THE INVENTION

Aspects and advantages of the invention will be set forth in part in the following description, or may be obvious from the description, or may be learned through practice of the invention.

In one aspect as defined in claim 1, the present disclosure is directed to a method for coating a component of a gas turbine engine. The method includes placing a first portion of the component in a masking chamber. The method further includes filling the masking chamber with a first coating material. The method further includes placing a masking lid on the masking chamber to isolate the first portion of the component from a second portion of the component. The method further includes placing an additional maskant around the masking lid and the top of the masking chamber so as to further isolate the first portion of the component of the gas turbine engine from a second portion of the component, wherein the isolating prevents the first coating material from damaging the second portion of the component. The method also includes simultaneously depositing the first coating material on the first portion of the component and a second coating material on the second portion of the component, wherein the first and second coating materials are different.

In a non-claimed aspect, the present disclosure is directed to a kit for coating a component of a gas turbine engine. The kit includes a first coating material and a different, second coating material. The kit also includes a maskant for isolating a first portion of the component of the gas turbine engine from a second portion of the component. Further, the kit includes a coating system configured to simultaneously deposit the first and second coating materials on the first and second portions of the component, respectively.

In an ebodiment, the method applies to a turbine blade of a gas turbine engine and includes placing a shank of the turbine blade in a masking chamber so as to isolate the shank from an airfoil of the turbine blade. The method also includes filling the masking chamber with a chromium-based powder coating. Another step includes simultaneously depositing an aluminum-based coating on the airfoil via diffusion coating.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWINGS

The subject matter which is regarded as the invention is particularly pointed out and distinctly claimed in the concluding part of the specification. The invention, however, may be best understood by reference to the following description taken in conjunction with the accompanying drawing figures in which:
FIG. 1 illustrates a schematic cross-sectional view of one embodiment of a gas turbine engine according to the present disclosure;
FIG. 2 illustrates a perspective view of one embodiment of a turbine blade of a gas turbine engine according to the present disclosure;
FIG. 3 illustrates a schematic view of one embodiment of a kit for coating a component of a gas turbine engine not part of the claimed invention;
FIG. 4 illustrates a schematic flow diagram of one embodiment of process steps for applying a high chromium coating to a component of a gas turbine engine according to the present disclosure;
FIG. 5 illustrates a schematic flow diagram of one embodiment of process steps for coating a component of a gas turbine engine according to the present disclosure; and
FIG. 6 illustrates a flow diagram of one embodiment of a method for coating a component of a gas turbine engine according to the present disclosure.

### DETAILED DESCRIPTION OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope of the invention. For instance, features illustrated or described as part of one embodiment can be used with another embodiment to yield a still further embodiment. Thus, it is intended that the present invention covers such modifications and variations as come within the scope of the appended claims.

Chemical elements are discussed in the present disclosure using their common chemical abbreviation, such as commonly found on a periodic table of elements. For example, aluminum is represented by its common chemical abbreviation Al; chromium is represented by its common chemical abbreviation Cr; and so forth.

As used herein, the terms "first", "second", and "third" may be used interchangeably to distinguish one component from another and are not intended to signify location or importance of the individual components.

The terms "upstream" and "downstream" refer to the relative direction with respect to fluid flow in a fluid pathway. For example, "upstream" refers to the direction from which the fluid flows, and "downstream" refers to the direction to which the fluid flows.

Generally, the present disclosure is directed to an improved system and method for simultaneously depositing multiple coatings at different locations on a component of a gas turbine engine. More specifically, in certain embodiments, the present disclosure provides an optimized composition of a chromium-based powder in a coating chamber to coat a shank of a turbine blade of a gas turbine engine and a vapor phase aluminum-based material in a coating furnace to coat an airfoil of the turbine blade. As such, the present disclosure provides a robust process that reduces time and costs associated with coating engine components.

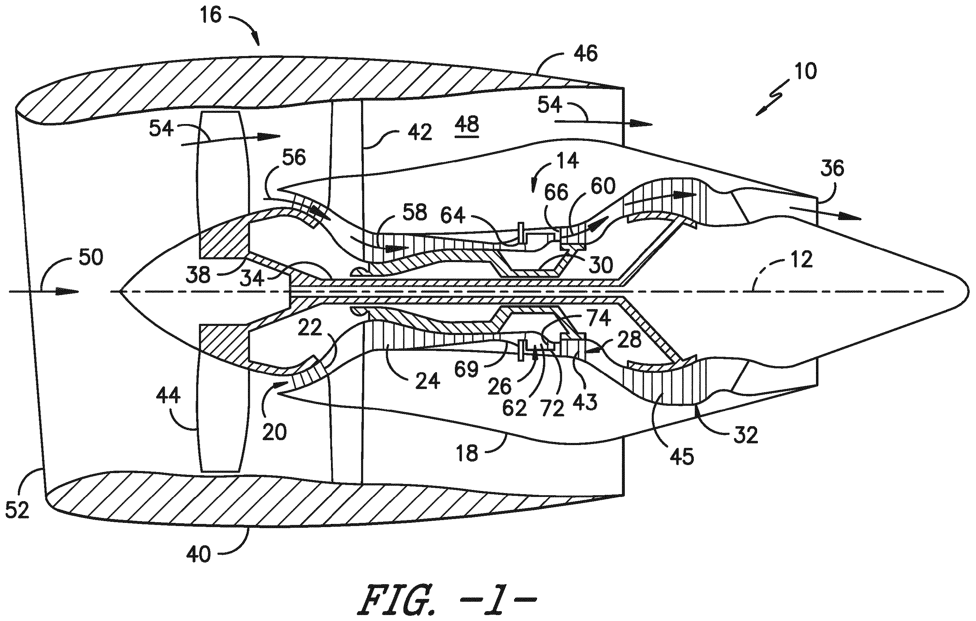

Referring now to the drawings, FIG. 1 illustrates a schematic cross-sectional view of one embodiment of a gas turbine engine 10 (high-bypass type) according to the present disclosure. More specifically, the gas turbine engine 10 may include an aircraft engine, e.g. for an airplane, helicopter, or similar. As shown, the gas turbine engine 10 has an axial longitudinal centerline axis 12 therethrough for reference purposes. Further, as shown, the gas turbine engine 10 preferably includes a core gas turbine engine generally identified by numeral 14 and a fan section 16 positioned upstream thereof. The core engine 14 typically includes a generally tubular outer casing 18 that defines an annular inlet 20. The outer casing 18 further encloses and supports a booster 22 for raising the pressure of the air that enters core engine 14 to a first pressure level. A high pressure, multi-stage, axial-flow compressor 24 receives pressurized air from the booster 22 and further increases the pressure of the air. The compressor 24 includes rotating blades and stationary vanes that have the function of directing and compressing air within the turbine engine 10. The pressurized air flows to a combustor 26, where fuel is injected into the pressurized air stream and ignited to raise the temperature and energy level of the pressurized air. The high energy combustion products flow from the combustor 26 to a first (high pressure) turbine 28 for driving the high pressure compressor 24 through a first (high pressure) drive shaft 30, and then to a second (low pressure) turbine 32 for driving the booster 22 and the fan section 16 through a second (low pressure) drive shaft 34 that is coaxial with the first drive shaft 30. After driving each of the turbines 28 and 32, the combustion products leave the core engine 14 through an exhaust nozzle 36 to provide at least a portion of the jet propulsive thrust of the engine 10.

The fan section 16 includes a rotatable, axial-flow fan rotor 38 that is surrounded by an annular fan casing 40. It will be appreciated that fan casing 40 is supported from the core engine 14 by a plurality of substantially radially-extending, circumferentially-spaced outlet guide vanes 42. In this way, the fan casing 40 encloses the fan rotor 38 and the fan rotor blades 44. The downstream section 46 of the fan casing 40 extends over an outer portion of the core engine 14 to define a secondary, or bypass, airflow conduit 48 that provides additional jet propulsive thrust.

From a flow standpoint, it will be appreciated that an initial airflow, represented by arrow 50, enters the gas turbine engine 10 through an inlet 52 to the fan casing 40. The airflow passes through the fan blades 44 and splits into a first air flow (represented by arrow 54) that moves through the conduit 48 and a second air flow (represented by arrow 56) which enters the booster 22.

The pressure of the second compressed airflow 56 is increased and enters the high pressure compressor 24, as represented by arrow 58. After mixing with fuel and being combusted in the combustor 26, the combustion products 60 exit the combustor 26 and flow through the first turbine 28. The combustion products 60 then flow through the second turbine 32 and exit the exhaust nozzle 36 to provide at least a portion of the thrust for the gas turbine engine 10.

Still referring to FIG. 1, the combustor 26 includes an annular combustion chamber 62 that is coaxial with the longitudinal centerline axis 12, as well as an inlet 64 and an outlet 66. As noted above, the combustor 26 receives an annular stream of pressurized air from a high pressure compressor discharge outlet 69. Fuel is injected from a fuel nozzle to mix with the air and form a fuel-air mixture that is provided to the combustion chamber 62 for combustion. Ignition of the fuel-air mixture is accomplished by a suitable igniter, and the resulting combustion gases 60 flow in an axial direction toward and into an annular, first stage turbine nozzle 72. The nozzle 72 is defined by an annular flow channel that includes a plurality of radially-extending, circumferentially-spaced nozzle vanes 74 that turn the gases so that they flow angularly and impinge upon the first stage turbine blades 43 of the first turbine 28. Similarly, the second stage turbine 32 may include a plurality of second stage turbine blades 45. As shown in FIG. 1, the first turbine 28 preferably rotates the high-pressure compressor 24 via the first drive shaft 30, whereas the low-pressure turbine 32 preferably drives the booster 22 and the fan rotor 38 via the second drive shaft 34.

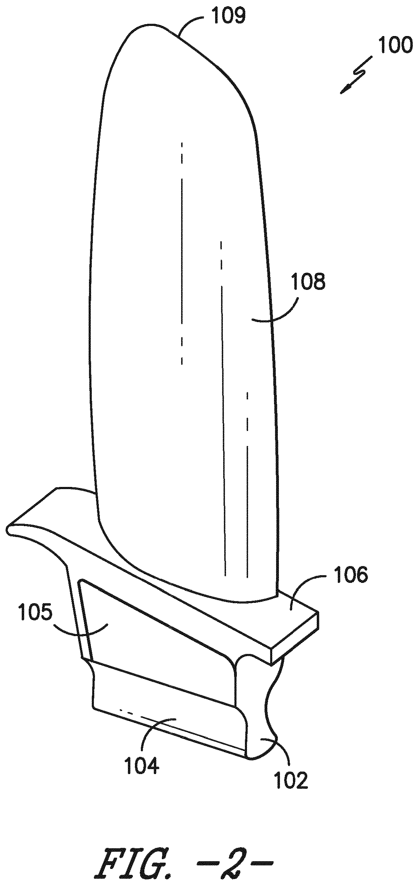

Referring now to FIG. 2, an exemplary turbine blade 100 of the gas turbine engine 10 of FIG. 1 is illustrated. As shown, the blade 100 is generally represented as being adapted for mounting to a disk or rotor (not shown) within the turbine section of the gas turbine engine 10. For this reason, the turbine blade 100 is represented as including a dovetail 102 for anchoring the blade 100 to a turbine disk by interlocking with a complementary dovetail slot formed in the circumference of the disk. As represented in FIG. 2, the interlocking features may include protrusions referred to as tangs 104 that engage recesses defined by the dovetail slot. The blade 100 is further shown as having a platform 106 that separates an airfoil 108 from a shank 105 on which the dovetail 102 is defined. The turbine blade 100 also includes a blade tip 109 disposed opposite the platform 106. As such, the blade tip 109 generally defines the radially outermost portion of the blade 100 and, thus, may be configured to be positioned adjacent to a stationary shroud (not shown) of the gas turbine engine 10.

Because they are directly subjected to hot combustion gases during operation of the engine, the airfoil 108, platform 106, and/or blade tip 109 typically have very demanding material requirements. The platform 106 and the blade tip 109 are further critical regions of the turbine blade 100 in that they create the inner and outer flowpath surfaces for the hot gas path within the turbine section. In addition, the platform 106 creates a seal to prevent mixing of the hot combustion gases with lower temperature gases to which the shank 105, its dovetail 102, and the turbine disk are exposed. Further, the blade tip 109 may be subjected to creep due to high strain loads and wear interactions between it and the shroud surrounding the blade tips 109. The dovetail 102 is also a critical region in that it is subjected to wear and high loads resulting from its engagement with a dovetail slot and the high centrifugal loading generated by the blade 100.

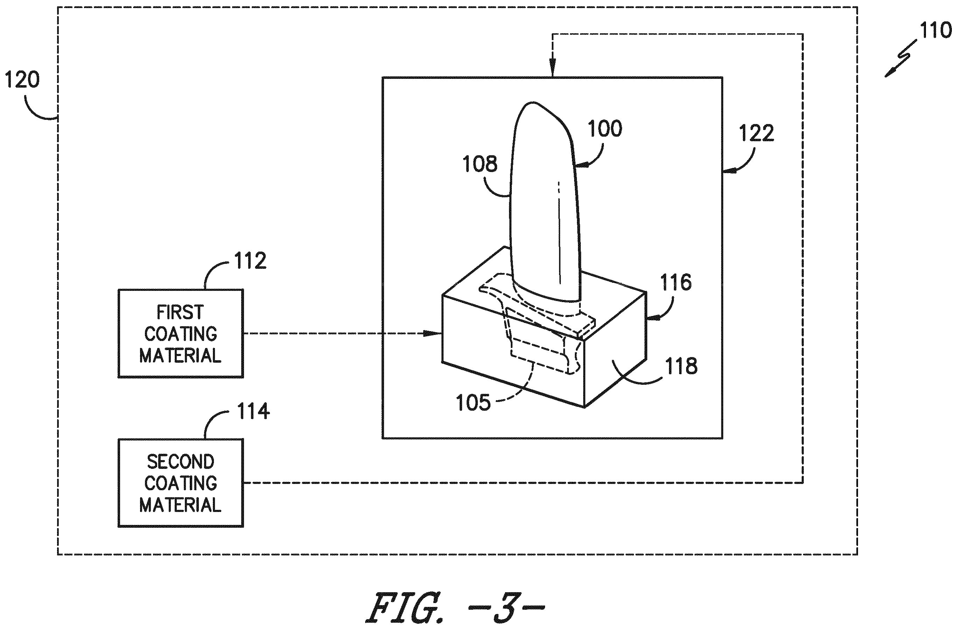

Thus, the turbine blade 100 is typically coated with various coatings that are dependent on turbine operations and associated temperatures. Though the present disclosure is described in reference to a turbine blade, it should be understood that the coating systems and methods as described herein may be applied to any gas turbine engine component. For example, in certain embodiments, the gas turbine engine components that may be coated according to the present disclosure in addition to the turbine blade may include but are not limited to fan blades, compressor blades, nozzles, shrouds, shroud supports, frames, turbine vanes, guide vanes, compressor vanes, or similar. Referring now to FIG. 3, a schematic view of a kit 110 for coating such components, e.g. the turbine blades 100, of the gas turbine engine 10 is illustrated. As shown, the kit 110 includes a first coating material 112 and a second, different coating material 114. Although the kit 110 is illustrated having two coating materials, it should be understood by those of ordinary skill in the art that any number of coating materials may be used according to the present disclosure.

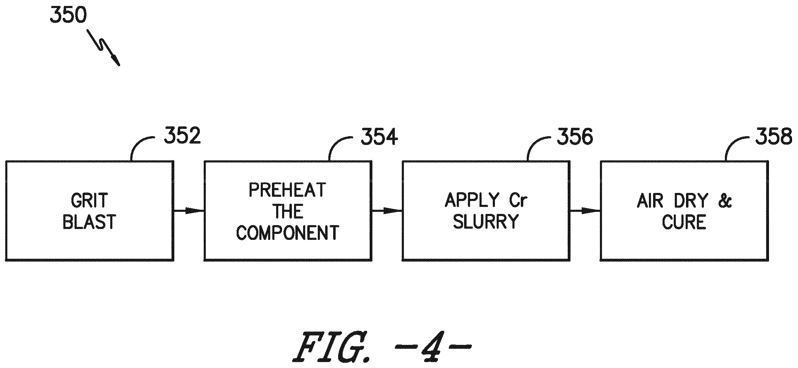

Further, the first and second coating materials 112, 114 may include any suitable coating materials, including but not limited to chromium-based coatings, aluminum-based coatings, silicon-based coatings, platinum coatings, palladium coatings, or any other suitable coating materials. For example, the chromium-based coatings as described herein may include the chromium coating and related chromizing process as described in U.S. Patent Application Publication No.: 2010/0151124 entitled "Slurry Chromizing Process" filed on August 3, 2007. More specifically, in certain embodiments, the chromium-based coatings as described herein may include high chromium. As used herein, high chromium generally refers to chromium applied to the engine component via a specific process. For example, as shown in FIG. 4, the process 350 for applying the high chromium as described herein includes grit blasting 352 the component such that the coating will be evenly and efficiently applied to the component. The component (or a portion thereof) is then placed in a masking chamber 118, which will be described in more detail below. The process 350 further includes preheating 354 the component to a predetermined temperature and applying 356 a chromium slurry to the component. For example, in certain embodiments, the chromium slurry may be applied to the component by filling the masking chamber 118 with the chromium slurry. The process 350 also includes air drying and curing 358 the chromium so as to coat the component. More specifically, the step of curing the chromium may include heating the chromium slurry at a temperature (e.g. from about 1500°F to about 2000°F, i.e. from about 815°C to 1095°C) for a predetermined time period (e.g. from about one (1) hour to about ten (10) hours).

In addition, in particular embodiments, the coating materials 112, 114 may include aluminide (i.e. Al coating over a Ni, Co, or Fe base alloy), chromide (i.e. Cr coating over Ni, Co, or Fe base alloy), silicide (i.e. silicon coating over Ni, Co, Fe base alloy), Pt-Al (i.e. platinum plating then an aluminide coating), Pd-Al (i.e. palladium plating then an aluminide coating, Hf -Al (i.e. hafniding and aluminiding), Cr-Al on one surface with pure chromide or aluminide on another surface, Al-Si on one surface with pure Cr or Al on another surface, Al with 5%Si/Cr coating, or any other suitable coatings or combinations thereof.

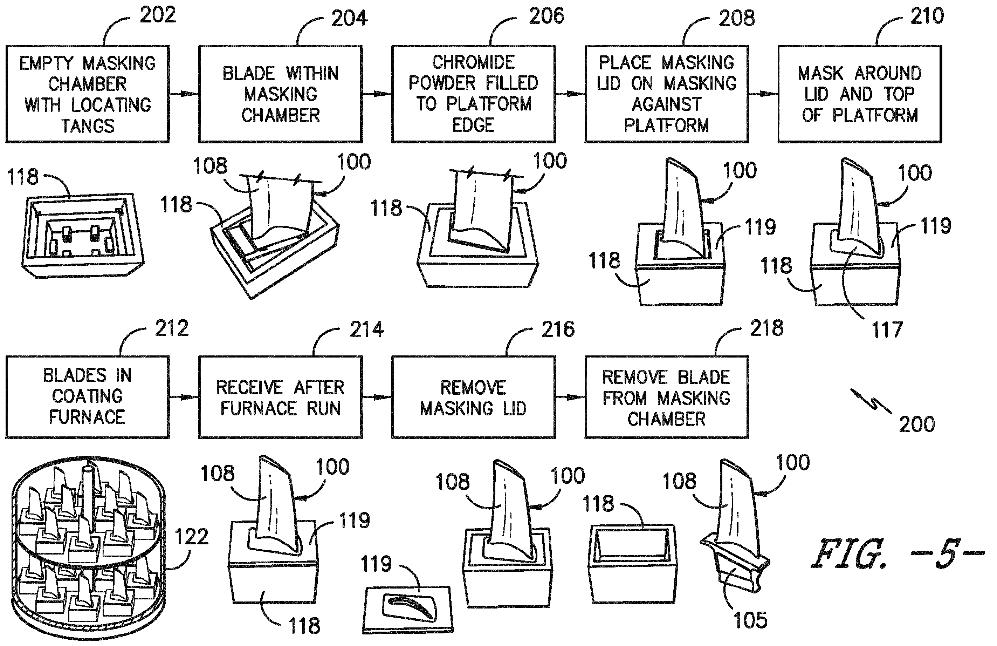

The kit 110 also includes a maskant 116 for isolating a first portion of the component from a second portion of the component. More specifically, as shown in the illustrated embodiment, the maskant 116 may include a masking chamber 118. In such an embodiment, the masking chamber 118 is configured to receive a first portion of the component, i.e. the shank 105 of the turbine blade 100, so as to isolate the first portion from the second portion, i.e. the airfoil 108 of the turbine blade 100, which is described in more detail in regards to FIG. 5 below.

Further, as shown, the kit 110 includes a coating system 120 configured to simultaneously deposit the first and second coating materials 112, 114 on the first and second portions 105, 108 of the component, respectively. For example, in one embodiment, the masking chamber 118 may be filled with the first coating material 112, e.g. a chromium-based powder. In addition, as shown, the coating system 120 may include a coating furnace or chamber 122 configured to apply the second coating material 114 on the second portion 108 of the component, i.e. the airfoil 108 of the turbine blade 100 as the first coating material is coating the first portion of the component. Thus, in such embodiments, the second coating material 114 may include a vapor-based aluminide material.

Referring now to FIG. 5, a schematic flow diagram of one embodiment of a process 200 for coating the turbine blade 10 of the gas turbine engine 10 is illustrated. As shown at 202, the process 200 includes providing an empty masking chamber 118 with optional locating tangs that are configured to engage the tang 104 of shank 105 of the turbine blade 100 so as to retain the turbine blade 100 therein. Thus, as shown at 204, the process 200 includes placing the turbine blade 100 within the masking chamber 118. As shown at 206, the process 200 includes filling the masking chamber 118 to the platform edge with the first coating material 112, which as mentioned, may be a chromium-based powder. As shown at 208, the process 200 includes placing a masking lid 119 on the masking chamber 118 so as to isolate the airfoil 108 of the turbine blade 100 from the shank 105 of the turbine blade 100. As shown at 210, the process 200 also includes placing an additional maskant 117 (e.g. a maskant film or similar) around the masking lid 119 and the top of the masking chamber 118 so as to further isolate the airfoil 108 of the turbine blade 100 from the shank 105 of the turbine blade 100. Such isolation prevents the first coating material 112 from damaging the airfoil 108 of the turbine blade 100. As shown at 212, the process 200 includes placing the turbine blade 100 (or a plurality of turbine blades 100) in the coating furnace 122. Thus, the method 200 includes simultaneously depositing the first coating material 112 on the shank 105 of the turbine blade 100 and the second coating material 114 on the airfoil 108 of the turbine blade 100, i.e. via the coating furnace 122.

More specifically, in certain embodiments, the coating furnace 122 is configured to apply the second coating material 114 via diffusion coating. For typical diffusion coating processes, aluminum-based materials (e.g. aluminides), chrome-based materials, and/or silicon-based materials may be mixed with an activator (e.g. a halide activator) and heated via the coating furnace 122 or chamber to form gaseous metal compounds which result in the deposition of the metal on the surface of the part to be coated, i.e. the airfoil 108 of the turbine blade 100. Suitable temperatures for diffusion coating processes may be from about 1500°F (about 815°C) to about 2200°F (about 1205°C), more preferably from about 1900°F (about 1040°C) to about 2100°F (about 1150°C). Further, the turbine blade 100 may remain in the coating furnace 122 for any suitable amount of time during the diffusion coating process depending on a desired thickness of the coating. For example, in one embodiment, the turbine blade 100 may remain in the coating furnace from about four (4) hours to about six (6) hours. In additional embodiments, the turbine blade 100 may remain in the coating furnace 122 or chamber for less than four hours or for greater than six hours. Thus, the gaseous metal compounds decompose upon contact with the surfaces of the part, thereby depositing the diffusion coating on the surface thereof. In additional embodiments, the airfoil 108 (or second portion of the component) may coated using any other suitable coating techniques in addition to diffusion coating, including but not limited to slurry coating, plating, and/or pack or powder coating.

As shown at 214, the process 200 further includes removing the turbine blade 100 from the coating furnace 122 and allowing the blade 100 to cool. As shown at 216, the masking lid 119 can then be removed from atop the masking chamber 118. As shown at 218, the coated turbine blade 100 is removed from the masking chamber 118. Thus, the turbine blade 100 of the present disclosure is coated using a single-step coating process (i.e. both coatings are deposited onto the blade 100 in different locations at the same time).

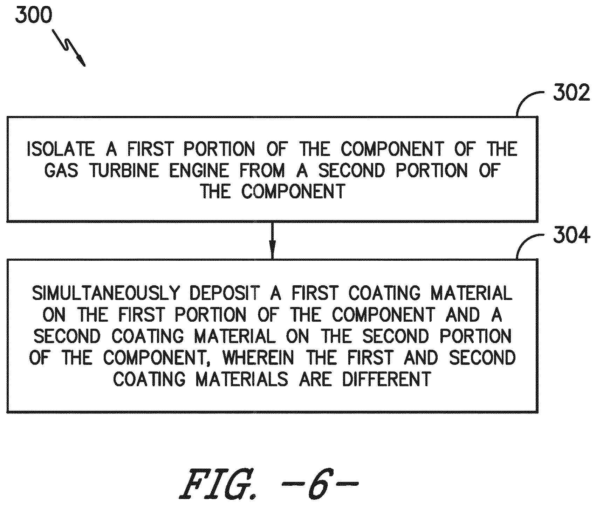

Referring now to FIG. 6, a flow diagram of one embodiment of a method 300 for coating a component of a gas turbine engine 10 is illustrated. As shown at 302, the method 300 includes isolating a first portion of the component of the gas turbine engine from a second portion of the component. As shown at 304, the method 300 includes simultaneously depositing a first coating material on the first portion of the component and a second coating material on the second portion of the component, wherein the first and second coating materials are different.

As mentioned, the component of the gas turbine engine 10 may include any suitable component such as a turbine blade, a fan blade, a compressor blade, a nozzle, shrouds, shroud supports, frames, a turbine vane, a guide vane, or a compressor vane. Thus, when coating a turbine blade, the step of isolating the first portion of the blade of the gas turbine engine 10 from the second portion of the blade may include placing a shank of the blade in a masking chamber and placing a masking lid on the masking chamber against a platform of an airfoil of the blade so as to isolate the shank from the airfoil.

In further embodiments, the first and second coating materials may include chromium-based coatings, aluminum-based coatings, silicon-based coatings, platinum coatings, palladium coatings, or any other suitable coating materials such as those described herein. More specifically, the first coating material may include a chromium-based material, whereas the second coating material may include an aluminum-based material. In such embodiments, the step of simultaneously depositing the first coating material on the first portion of the component and the second coating material on the second portion of the component may include filling the masking chamber with the chromium-based material before placing the masking lid on the masking chamber so as to coat the shank and depositing the airfoil with the aluminum-based material. In particular embodiments, the chromium-based material may include a powder.

In additional embodiments, the step of depositing the airfoil with the aluminum-based material may include placing the turbine blade in a coating furnace and exposing the airfoil to a vapor phase aluminum-based material so as to coat the airfoil, as previously described.

In yet another embodiment, the method 300 may further include removing the turbine blade from the coating furnace, cooling the turbine blade while the shank remains in the masking chamber, removing the masking lid from the masking chamber, and removing the shank from the masking chamber.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A method (200) for coating a component (100) of a gas turbine engine (10), the method comprising:
placing (204) a first portion (105) of the component (100) in a masking chamber (118);
filling (206) the masking chamber (118) with a first coating material (112);
placing (208) a masking lid (119) on the masking chamber (118) to isolate the first portion (105) of the component (100) from a second portion of the component (100);
placing (210) an additional maskant (117) around the masking lid (119) and the top of the masking chamber (118) so as to further isolate the first portion (105) of the component (100) of the gas turbine engine (10) from the second portion (108) of the component (100), wherein the isolating prevents the first coating material (112) from damaging the second portion (108) of the component (100); and
simultaneously depositing the first coating material (112) on the first portion (105) of the component (100) and a second coating material (114) on the second portion (108) of the component (100), wherein the first and second coating materials (112, 114) are different.

2. The method (200) of claim 1, wherein the component of the gas turbine engine (10) comprises at least one of a turbine blade (100), a fan blade, a compressor blade, a nozzle, shrouds, shroud supports, frames, a turbine vane, a guide vane, or a compressor vane.

3. The method (200) of claim 1 or claim 2, wherein simultaneously depositing the first coating material (112) on the first portion (105) of the component (100) and the second coating material (114) on the second portion (108) of the component comprises at least one of diffusion coating, plating, slurry coating, or powder coating.

4. The method (200) of any preceding claim, wherein the component comprises a turbine blade (100), the first portion (105) comprises a shank (105) of the turbine blade (100) and the second portion (108) comprises an airfoil (108) of the turbine blade (100).

5. The method (200) of claim 4, wherein
placing (208) the masking lid (119) on the masking chamber (118) comprises placing the masking lid against a platform (106) of the airfoil (108) so as to isolate the shank (105) from the airfoil (108).

6. The method (200) of any preceding claim, wherein the first coating material (112) comprises a chromium-based material and the second coating material (114) comprises an aluminum-based material.

7. The method (200) of claim 6 when dependent on claim 4, wherein simultaneously depositing the first coating material (112) on the first portion (105) of the component and the second coating material (114) on the second portion (108) of the component further comprises:
filling the masking chamber (118) with the chromium-based material before placing the masking lid (119) on the masking chamber (118) so as to coat the shank (105), and depositing the airfoil (108) with the aluminum-based material.

8. The method (200) of claim 7, wherein depositing the airfoil (108) with the aluminum-based material further comprises:
placing (212) the turbine blade (100) in a coating furnace (122), and exposing the airfoil (108) to a vapor phase aluminum-based material so as to coat the airfoil (108).

9. The method (200) of claim 8, further comprising:
removing (214) the turbine blade (100) from the coating furnace (122), cooling the turbine blade (100) while the shank (105) remains in the masking chamber (118), removing (216) the masking lid (119) from the masking chamber (118), and removing the shank (105) from the masking chamber (118).

10. The method (200) of any preceding claim, wherein simultaneously depositing the first coating material (112) on the first portion (105) of the component further comprises:
grit blasting the first portion (105) of the component, placing the first portion (105) of the component in the masking chamber (118), preheating the component to a predetermined temperature, filling the masking chamber (118) with a chromium slurry, curing the chromium slurry onto the component, heating the chromium-coated component at a temperature for a predetermined time period so as to form a chromium coating on the first portion (105) of the component.

11. The method (200) of any preceding claim, wherein the first and second coating materials (112, 114) comprise at least one of chromium-based coatings, aluminum-based coatings, silicon-based coatings, platinum coatings, or palladium coatings.

## Patentansprüche

1. Verfahren (200) zum Beschichten einer Komponente (100) eines Gasturbinentriebwerks (10), wobei das Verfahren umfasst:
Anbringen (204) eines ersten Abschnitts (105) der Komponente (100) in einer Maskierungskammer (118);
Füllen (206) der Maskierungskammer (118) mit einem ersten Beschichtungsmaterial (112);
Anbringen (208) eines Maskierungsdeckels (119) auf der Maskierungskammer (118), um den ersten Abschnitt (105) der Komponente (100) von einem zweiten Abschnitt der Komponente (100) zu isolieren;
Anbringen (210) einer zusätzlichen Maskierung (117) um den Maskierungsdeckel (119) und die Oberseite der Maskierungskammer (118), um den ersten Abschnitt (105) der Komponente (100) des Gasturbinentriebwerks (10) weiter vom zweiten Abschnitt (108) der Komponente (100) zu isolieren, wobei die Isolierung verhindert, dass das erste Beschichtungsmaterial (112) den zweiten Abschnitt (108) der Komponente (100) beschädigt; und
gleichzeitiges Aufbringen des ersten Beschichtungsmaterials (112) auf den ersten Abschnitt (105) der Komponente (100) und eines zweiten Beschichtungsmaterials (114) auf den zweiten Abschnitt (108) der Komponente (100), wobei das erste und das zweite Beschichtungsmaterial (112, 114) unterschiedlich sind.

2. Verfahren (200) nach Anspruch 1, wobei die Komponente des Gasturbinentriebwerks (10) mindestens eines von einem Turbinenschaufelblatt (100), einem Lüfterblatt, einem Kompressorblatt, einer Düse, Verkleidungen, Verkleidungsstützen, Rahmen, einer Turbinenschaufel, einer Leitschaufel oder einer Kompressorschaufel umfasst.

3. Verfahren (200) nach Anspruch 1 oder 2, wobei das gleichzeitige Aufbringen des ersten Beschichtungsmaterials (112) auf den ersten Abschnitt (105) der Komponente (100) und des zweiten Beschichtungsmaterials (114) auf den zweiten Abschnitt (108) der Komponente mindestens eines der folgenden Verfahren umfasst: Diffusionsbeschichtung, Plattieren, Slurry-Beschichtung oder Pulverbeschichtung.

4. Verfahren (200) nach einem der vorstehenden Ansprüche, wobei die Komponente eine Turbinenschaufel (100) umfasst, wobei der erste Abschnitt (105) einen Schaft (105) der Turbinenschaufel (100) umfasst und der zweite Abschnitt (108) ein Tragflächenprofil (108) der Turbinenschaufel (100) umfasst.

5. Verfahren (200) nach Anspruch 4, wobei
das Anbringen (208) des Maskierungsdeckels (119) auf die Maskierungskammer (118) das Anbringen des Abdeckungsdeckels auf eine Plattform (106) des Tragflächenrprofils (108) umfasst, um den Schaft (105) vom Tragflächenprofil (108) zu isolieren.

6. Verfahren (200) nach einem der vorstehenden Ansprüche, wobei das erste Beschichtungsmaterial (112) ein Material auf Chrombasis umfasst und das zweite Beschichtungsmaterial (114) ein Material auf Aluminiumbasis umfasst.

7. Verfahren (200) nach Anspruch 6, wenn abhängig von Anspruch 4, wobei das gleichzeitige Aufbringen des ersten Beschichtungsmaterials (112) auf den ersten Abschnitt (105) der Komponente und des zweiten Beschichtungsmaterials (114) auf den zweiten Abschnitt (108) der Komponente ferner umfasst:
Befüllen der Maskierungskammer (118) mit dem Material auf Chrombasis, bevor der Maskierungsdeckel (119) auf die Maskierungskammer (118) aufgesetzt wird, um den Schaft (105) zu beschichten, und das Aufbringen des Materials auf Aluminiumbasis auf das Tragflächenprofil (108).

8. Verfahren (200) nach Anspruch 7, wobei das Aufbringen des aluminiumbasierten Materials auf das Tragfläachenprofil (108) ferner umfasst:
Anbringen (212) der Turbinenschaufel (100) in einen Beschichtungsofen (122) und das Aussetzen des Tragflächenprofils (108) einem aluminumbasierten Material in der Dampfphase, um das Tragfächenprofil (108) zu beschichten.

9. Verfahren (200) nach Anspruch 8, ferner umfassend:
Entfernen (214) der Turbinenschaufel (100) aus dem Beschichtungsofen (122), Kühlen der Turbinenschaufel (100), während der Schaft (105) in der Maskierungskammer (118) verbleibt, Entfernen (216) des Maskierungsdeckels (119) von der Maskierungsskammer (118) und Entfernen des Schafts (105) aus der Maskierungskammer (118).

10. Verfahren (200) nach einem der vorstehenden Ansprüche, wobei das gleichzeitige Aufbringen des ersten Beschichtungsmaterials (112) auf den ersten Abschnitt (105) der Komponete ferner umfasst:
Sandstrahlen des ersten Abschnitts (105) der Komponente, Anbringen des ersten Abschnitts (105) der Komponente in die Maskierungskammer (118), Vorwärmen der Komponente auf eine vorbestimmte Temperatur, Füllen der Maskierungskammer (118) mit einer Chrom-Slurry, Aushärten des Chrom-Slurry auf der Komponente, Erhitzen der chrombeschichteten Komponente bei einer Temperatur für einen vorbestimmten Zeitraum, um eine Chrombeschichtung auf dem ersten Abschnitt (105) der Komponente zu bilden.

11. Verfahren (200) nach einem der vorstehenden Ansprüche, wobei das erste und zweite Beschichtungsmaterial (112, 114) mindestens eine von Beschichtungen auf Chrombasis, Beschichtungen auf Aluminiumbasis, Beschichtungen auf Siliziumbasis, Platinbeschichtungen oder Palladiumbeschichtungen umfassen.

## Revendications

1. Procédé (200) pour revêtir un composant (100) d'un moteur à turbine à gaz (10), le procédé comprenant :
le placement (204) d'une première partie (105) du composant (100) dans une chambre de masquage (118) ;
le remplissage (206) de la chambre de masquage (118) avec un premier matériau de revêtement (112) ;
le placement (208) d'un couvercle de masquage (119) sur la chambre de masquage (118) afin d'isoler la première partie (105) du composant (100) d'une deuxième partie du composant (100) ;
le placement (210) d'un masquant supplémentaire (117) autour du couvercle de masquage (119) et du haut de la chambre de masquage (118) de manière à isoler davantage la première partie (105) du composant (100) du moteur à turbine à gaz (10) de la deuxième partie (108) du composant (100), où l'isolation empêche le premier matériau de revêtement (112) d'endommager la deuxième partie (108) du composant (100) ; et
le dépôt simultané du premier matériau de revêtement (112) sur la première partie (105) du composant (100) et d'un deuxième matériau de revêtement (114) sur la deuxième partie (108) du composant (100), où les premier et deuxième matériaux de revêtement (112, 114) sont différents.

2. Procédé (200) selon la revendication 1, où le composant du moteur à turbine à gaz (10) comprend au moins un élément parmi une pale de turbine (100), une pale de ventilateur, une pale de compresseur, une buse, des carénages, des supports de carénage, des cadres, une aube de turbine, une aube de guidage ou une aube de compresseur.

3. Procédé (200) selon la revendication 1 ou la revendication 2, où le dépôt simultané du premier matériau de revêtement (112) sur la première partie (105) du composant (100) et du deuxième matériau de revêtement (114) sur la deuxième partie (108) du composant comprend au moins un élément parmi un revêtement par diffusion, un placage, un revêtement par suspension ou un revêtement par poudre.

4. Procédé (200) selon l'une quelconque des revendications précédentes, où le composant comprend une pale de turbine (100), la première partie (105) comprend une tige (105) de la pale de turbine (100) et la deuxième partie (108) comprend une surface portante (108) de la pale de turbine (100).

5. Procédé (200) selon la revendication 4, où
le placement (208) du couvercle de masquage (119) sur la chambre de masquage (118) comprend le placement du couvercle de masquage contre une plate-forme (106) de la surface portante (108) de manière à isoler la tige (105) de la surface portante (108).

6. Procédé (200) selon l'une quelconque des revendications précédentes, où le premier matériau de revêtement (112) comprend un matériau à base de chrome et le deuxième matériau de revêtement (114) comprend un matériau à base d'aluminium.

7. Procédé (200) selon la revendication 6 lorsqu'elle dépend de la revendication 4, où le dépôt simultané du premier matériau de revêtement (112) sur la première partie (105) du composant et du deuxième matériau de revêtement (114) sur la deuxième partie (108) du composant comprend en outre :
le remplissage de la chambre de masquage (118) avec le matériau à base de chrome avant le placement du couvercle de masquage (119) sur la chambre de masquage (118) de manière à recouvrir la tige (105), et le dépôt du matériau à base d'aluminium sur la surface portante (108).

8. Procédé (200) selon la revendication 7, où le dépôt du matériau à base d'aluminium sur la surface portante (108) comprend en outre :
le placement (212) de la pale de turbine (100) dans un four de revêtement (122), et l'exposition de la surface portante (108) à un matériau à base d'aluminium en phase vapeur afin de revêtir la surface portante (108).

9. Procédé (200) selon la revendication 8, comprenant en outre :
le retrait (214) de la pale de turbine (100) du four de revêtement (122), le refroidissement de la pale de turbine (100) tandis que la tige (105) reste dans la chambre de masquage (118), le retrait (216) du couvercle de masquage (119) de la chambre de masquage (118), et le retrait de la tige (105) de la chambre de masquage (118).

10. Procédé (200) selon l'une quelconque des revendications précédentes, où le dépôt simultané du premier matériau de revêtement (112) sur la première partie (105) du composant comprend en outre :
le sablage de la première partie (105) du composant, le placement de la première partie (105) du composant dans la chambre de masquage (118), le préchauffage du composant à une température prédéterminée, le remplissage de la chambre de masquage (118) avec une suspension de chrome, le durcissement de la suspension de chrome sur le composant, le chauffage du composant revêtu de chrome à une température pendant une période de temps prédéterminée de manière à former un revêtement de chrome sur la première partie (105) du composant.

11. Procédé (200) selon l'une quelconque des revendications précédentes, où les premier et deuxième matériaux de revêtement (112, 114) comprennent au moins un élément parmi des revêtements à base de chrome, des revêtements à base d'aluminium, des revêtements à base de silicium, des revêtements à base de platine ou des revêtements à base de palladium.
